# FASCICULE DE BREVET EUROPEEN

(11) **EP 1 946 253 B1**
(45) Date de publication et mention de la délivrance du brevet: **22.04.2015**
(21) Numéro de dépôt: 06831054.9
(22) Date de dépôt: 02.11.2006
(51) Int. Cl.: G06K 19/077

(54) **PROCEDE DE FABRICATION D'UNE CARTE A MICROCIRCUIT ET CARTE A MICROCIRCUIT, NOTAMMENT A ANTENNE MAGNETIQUE**
CHIPKARTEN-HERSTELLUNGSVERFAHREN UND INSBESONDERE MIT EINER MAGNETANTENNE AUSGESTATTETE CHIPKARTE
SMART CARD PRODUCING METHOD AND A SMART CARD IN PARTICULAR PROVIDED WITH A MAGNETIC ANTENNA

(30) Priorité: 08.11.2005 FR 0511338
(43) Date de publication de la demande: 23.07.2008
(73) Titulaire: OBERTHUR TECHNOLOGIES, 92700 Colombes (FR)
(72) Inventeur: LAUNAY, François, 14610 Epron (FR); VENAMBRE, Jacques, 14123 Ifs (FR); LIMELETTE, Yann, Chester Springs, PA 19425 (US); BARBOTIN, Aurélie, 35200 Rennes (FR)
(74) Mandataire: Santarelli
(86) Numéro de dépôt international: PCT/FR2006/002450
(87) Numéro de publication internationale: WO 2007/054632

(56) Documents cités:
- EP-A- 0 920 056
- EP-A- 0 952 542
- EP-A- 1 107 175
- EP-A1- 1 031 939
- DE-A1- 10 064 411
- DE-A1- 19 646 209
- DE-A1- 19 709 985

## Description

L'invention concerne un procédé de fabrication d'une carte à microcircuit. Ce procédé est particulièrement intéressant dans le cas des cartes sans contact notamment en ce qu'il permet un faible coût de revient. L'invention vise également une carte à antenne magnétique.

Le développement des étiquettes (parfois dénommées par le mot anglais *"tags"*) sans contact pour les applications de traçabilité et d'identification en radiofréquences a conduit au développement de technologies à très faible coût en utilisant des procédés de report de puce dits *"monté-retourné"* (ou *"flip-chip"* en anglais). La généralisation de cette technique aux cartes à microcircuit ou cartes à puce), en particulier pour des marchés de type identité ou bancaire s'est heurtée à des problèmes de fiabilité limitant leur usage à des microcircuits de petites dimensions (1 ou 2 mm²), et par conséquent de performances limitées incompatibles avec des applications de hautes sécurité.

L'origine de ces problèmes réside dans la sensibilité du procédé de flip-chip aux pressions et températures utilisées lors de la lamination des structures plastiques ainsi qu'aux contraintes mécaniques de flexion, torsion et pression s'exerçant sur les cartes lors de leur utilisation sur le terrain.

Typiquement, les défauts rencontrés sont liés à une cassure de la puce électronique ou / et à une déconnexion de celle-ci de l'antenne. La présente invention se propose de remédier à ses inconvénients en définissant un procédé peu onéreux permettant d'obtenir les niveaux de fiabilité requis par les applications de cartes à microcircuit, en particulier celles utilisant un microprocesseur.

Dans ce but notamment, l'invention propose un procédé défini par la revendication 1.

On évite ainsi que l'adhésif ne flue de façon excessive lors de la lamination, ce qui risquerait d'entraîner une rupture des connexions entre la plage et le microcircuit.

On connait déjà, d'après les documents DE - 196 46 209 ou EP-0 920 056, des procédés de fabrication de cartes à microcircuit mettant en oeuvre des étapes de dépôt d'un microcircuit sur une surface avec interposition d'un adhésif et de lamination à chaud d'au moins une couche additionnelle à une température maximale à laquelle l'adhésif est visqueux. Toutefois, ces procédés ne prévoient pas d'étape intermédiaire de durcissement de l'adhésif.

Le document DE 100 64 411 décrit la fabrication d'un document de sécurité comprenant un microcircuit. Une tête chauffante et un adhésif sont utilisés pour fixer le microcircuit sur des contacts.

Selon un mode de réalisation, l'adhésif est une colle thermodurcissable. Dans ce cas, on peut considérer que la température de ramollissement de l'adhésif est égale à la température de transition vitreuse de la colle, ce qui permet une détermination précise de cette température.

Selon un autre aspect, éventuellement indépendant de ce qui précède, on peut prévoir que le microcircuit ait une épaisseur dans une direction essentiellement perpendiculaire à ladite surface inférieure à 160 µm afin de ne pas être endommagé par les efforts de flexion subis par la carte. Ladite épaisseur est toutefois de préférence supérieure à 120 µm afin de conserver une rigidité suffisante.

A titre de comparaison, la carte à microcircuit a, selon la norme ISO 7816, une épaisseur comprise entre 680 µm et 840 µm.

Le procédé est par exemple de type flip-chip, c'est-à-dire qu'au moins un contact du microcircuit est situé face à ladite plage de connexion avec interposition d'un élément conducteur.

La carte à microcircuit peut comprendre une antenne magnétique formée d'un premier enroulement comprenant au moins une spire et d'un second enroulement comprenant au moins une spire, avec une zone d'embossage de la carte située à l'extérieur du premier enroulement et à l'intérieur du second enroulement.

On optimise ainsi la surface équivalente de l'antenne en dépit de la présence de la zone d'embossage.

Dans le mode de réalisation présenté, le premier enroulement et le second enroulement sont connectés en série.

Le second enroulement est par exemple situé à la périphérie de la carte à microcircuit, tandis que le premier enroulement peut être situé dans une partie rectangulaire de la carte à microcircuit située à l'extérieur de la zone d'embossage. Cette solution est particulièrement bien adaptée à la structure de la carte. Ladite partie rectangulaire est par exemple celle qui porte le microcircuit.

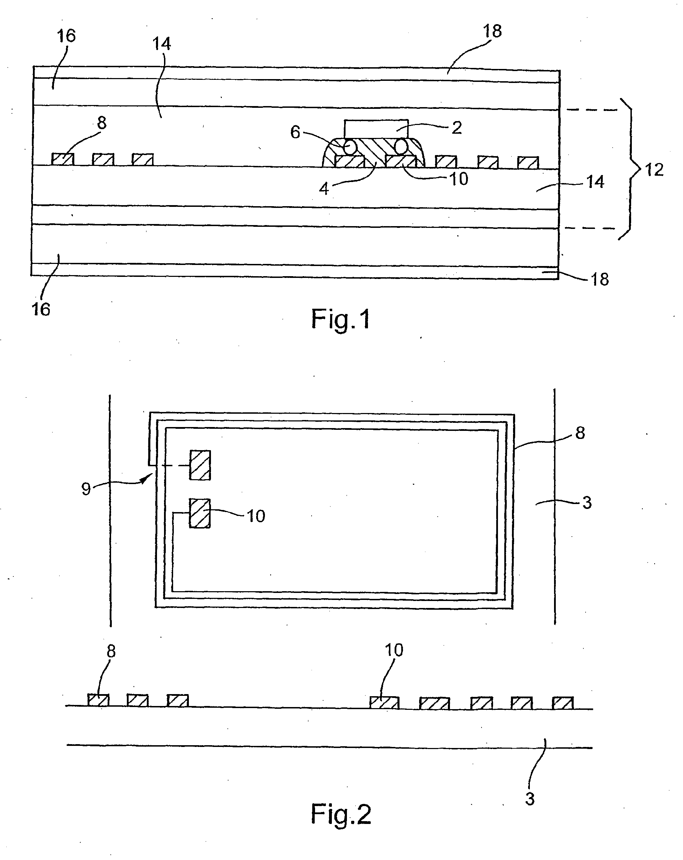

On a représenté schématiquement en figure 1 la structure dans son épaisseur d'une carte à microcircuit conforme aux enseignements de l'invention. Dans cette représentation, les dimensions dans l'épaisseur sont exagérées par rapport aux dimensions transverses pour faciliter la perception des différentes couches.

Dans cette carte, une antenne 8 est déposée sur un film souple 3 (ou support) d'épaisseur comprise entre 40 et 100 µm afin de limiter les phénomènes de déformation (ou tuilage) lors de l'opération de lamination de la structure plastique avec des matériaux différents comme le PVC. Ce support 3 est compatible avec les températures utilisées lors de l'opération de réalisation de la structure flip-chip et doit donc typiquement résister à des températures supérieures à 100°C, sans quoi le microcircuit 2 aurait tendance à s'enfoncer dans la matière lors de l'opération de report et à rompre ainsi les plages de connexion ou les spires de l'antenne. Pour ce faire, le support 3 est par exemple réalisé en PET (Polyéthylène téréphtalate).

Un adhésif 4, ici une colle isolante (ou en variante anisotrope), est déposé comme décrit plus loin à l'emplacement de report du microcircuit 2 sur le support 3 de l'antenne 8. La colle 4 utilisée a une température de ramollissement (qui correspond dans le cas d'une colle thermodurcissable, par exemple de type époxy, à la température de transition vitreuse) qui n'est pas inférieure de plus de 40°C à la température maximale du cycle de lamination à chaud de la structure plastique. On utilise par exemple pour ce faire une colle MK055 proposée par la société DELO. Il s'agit d'une colle thermodurcissable dont la température de transition vitreuse est de 115 °C selon la méthode DSC (pour *"Differential Scanning Calorimetry",* c'est-à-dire en français calorimétrie différentielle à balayage).

En variante, l'adhésif pourrait être un film adhésif à base de matériaux thermoplastiques dont la température de ramollissement dépend des températures de transition vitreuse de ses composants.

La carte comprend un microcircuit 2 (microprocesseur ou mémoire, parfois dénommé *"puce électronique"*) d'une épaisseur inférieure ou égale à 160 µm, c'est-à-dire suffisamment fine pour résister aux contraintes de flexion qui s'appliqueront sur la carte. L'épaisseur du microcircuit 2 est par ailleurs supérieure à 120 µm afin d'assurer une rigidité suffisante.

Des surépaisseurs conductrices 6 ont été réalisées sur les plages de métallisation 21 du microcircuit 2 afin d'assurer un contact avec l'antenne 8, comme décrit plus loin.

Deux couches de compensation 14 en matière plastique enserrent le support (film souple 3) ; elles ont été laminées à chaud de part et d'autre du film souple 3 portant l'antenne 8 et le microcircuit 2. On appellera *"prélaminé"* 12 la structure ainsi constituée.

La carte à microcircuit comprend également deux couches imprimées 16 sur leur face externe, laminées à chaud de part et d'autre du prélaminé 12, puis éventuellement deux couches 18 en matériau plastique transparent recouvrant les couches imprimées 16 pour protéger et qui peuvent être laminées en même temps que ces dernières.

En variante, un vernis de protection transparent peut être utilisé en remplacement de ces couches en matériau plastique transparent.

On va décrire à présent en référence aux figures 2 à 8 un exemple de procédé de fabrication d'une telle carte à microcircuit.

On réalise tout d'abord l'antenne 8 sur le film souple 3, par exemple par sérigraphie d'encre conductrice, par gravure de cuivre ou d'aluminium ou par croissance électrolytique d'un métal conducteur (usuellement le cuivre). On obtient alors la structure représentée en figure 2. L'antenne présente des plages de connexion 10 à ses extrémités, comme bien visible en figure 2.

On ne décrira pas ici en détail la réalisation du pont de bouclage 9 de l'antenne 8, qui peut être réalisé par exemple conformément aux enseignements de la demande de brevet FR 2 769 390.

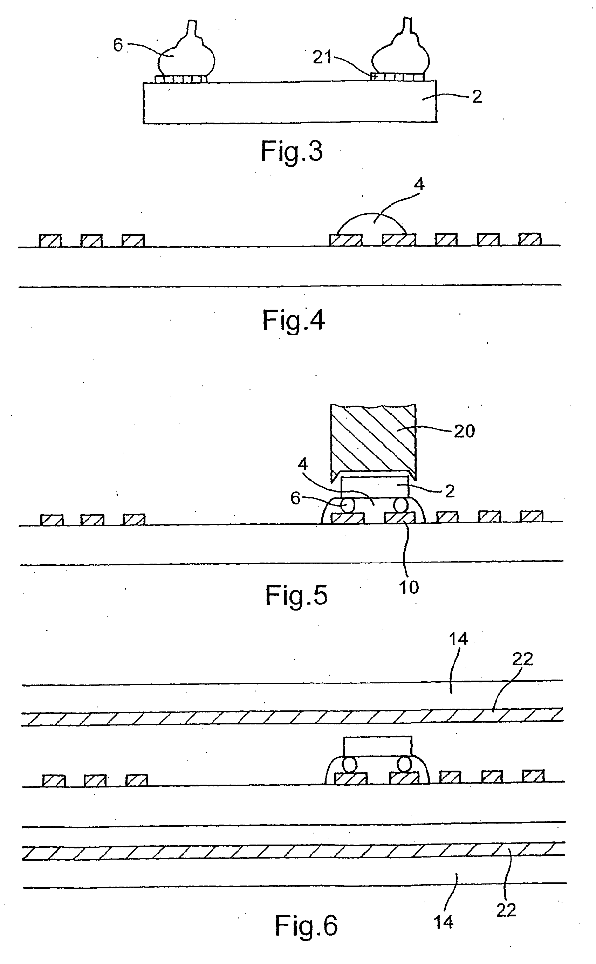

On procède par ailleurs au dépôt, sur les plages de contact 21 du microcircuit 2, d'excroissances conductrices 6 (ou *"bumps"* en anglais), comme illustré en figure 3. Ces surépaisseurs conductrices 6 peuvent être réalisées en différents métaux conducteurs ou en polymère conducteur.

On utilise préférablement dans ce procédé des bumps 6 réalisés par soudure filaire thermosonique (*"stud bumps"* en anglais).

On dépose d'autre part, sur l'emplacement servant à la réalisation des contacts, la colle isolante 4 (ou en variante anisotrope), par exemple une goutte de celle-ci, comme représenté en figure 4.

Cette colle 4 est choisie telle que sa température de ramollissement (i.e. sa température de transition vitreuse pour les thermodurcissables et les thermoplastiques de structure amorphe) soit assez élevée pour que la colle ne flue pas de façon excessive lors de la lamination (en particulier lors de l'application de la pression maximale du cycle de lamination), conduisant ainsi à une rupture des connexions entre l'antenne 8 et le microcircuit 2.

Pour ce faire, on peut prévoir par exemple que cette température de ramollissement ne soit pas inférieure de plus de 40° C à la température maximale du cycle de lamination.

On presse alors comme représenté en figure 5 les bumps 6 contre les plages de connexion 10 de l'antenne 8 à l'aide d'une tête de dépôt chauffante 20 du microcircuit 2 pour permettre une polymérisation ou un durcissement rapide de la colle 4 en température.

Afin de préparer l'opération de lamination des couches de compensation 14, on assemble tout d'abord ces couches de compensation de part et d'autre de l'inlay formé par le film souple 3, l'antenne 8 et le microcircuit 2. Un adhésif thermofusible 22 peut être déposé préalablement, soit sur les deux faces de l'inlay, soit sur les faces des couches de compensation 14, en vis à vis de l'inlay, comme représenté en figure 6.

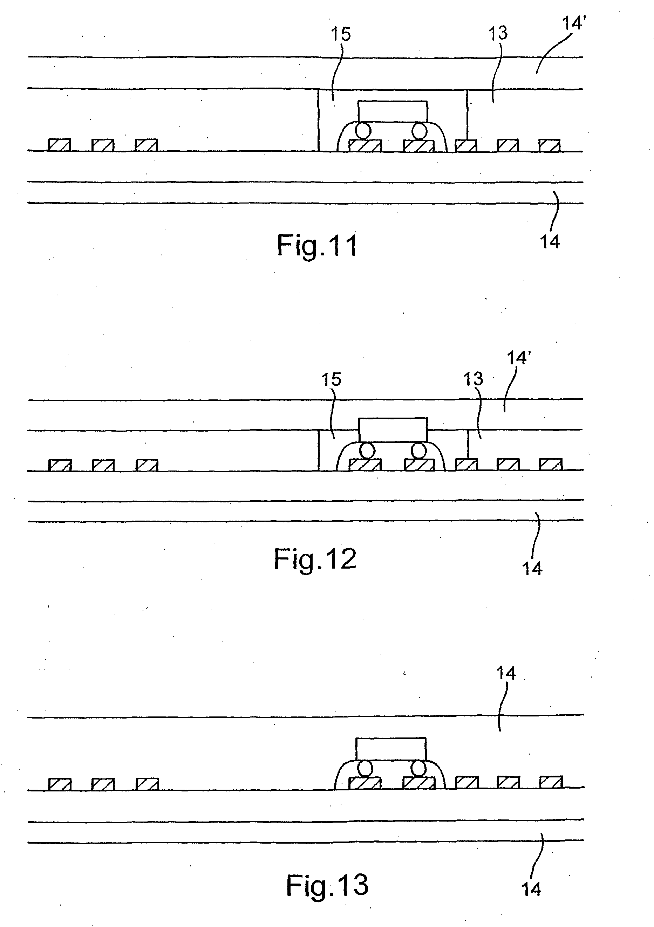

Plusieurs structures peuvent être utilisées à cette étape :
- une structure ajourée comprenant une première couche 13, dont l'épaisseur est supérieure à celle du microcircuit 8, ajourée au niveau de ladite puce, et une deuxième couche 14' utilisant un matériau ayant une température de ramollissement inférieure à celle de la première couche 13 (figure 11). Cette couche 14' viendra ainsi combler la cavité 15 de la première couche 13 par fluage lors de la lamination de la structure ;
- une structure semi-ajourée, différente de la structure sus-décrite par le fait que l'épaisseur de la première couche 13 est inférieure ou égale à celle du microcircuit 2 (figure 12).
- une structure non ajourée avec un matériau de faible température de ramollissement (par exemple 59° VICAT A) dont l'épaisseur avant lamination est supérieure à celle du composant (figure13).

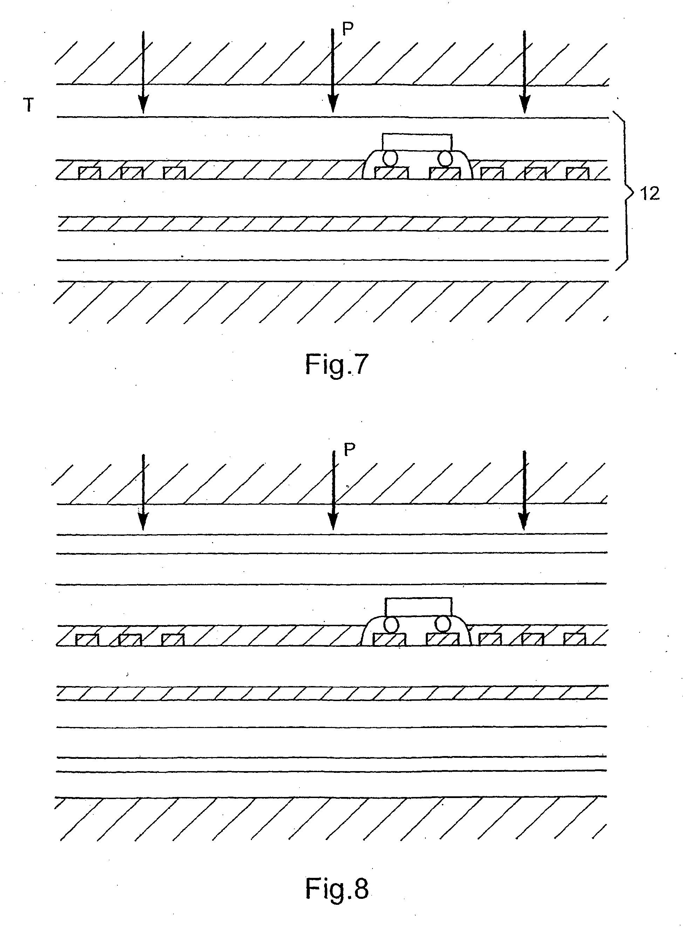

On procède alors, comme représenté en figure 7, au cycle de lamination des couches de compensation, qui comporte une montée en pression P progressive et un bref maintien en pression P maximale (durée par exemple inférieure à 4 mn) pour éviter les risques de déconnexion ou de casse du microcircuit 2.

Le prélaminé 12 ainsi réalisé peut alors être assemblé avec les couches 16 portant l'impression et les éventuelles couches transparentes 18 de protection (si un vernis n'est pas utilisé à cet effet), comme représenté en figure 8.

L'ensemble est alors laminé à chaud avec une température maximale, ici de l'ordre de 150°C. Grâce au choix de la colle susmentionné, cette température maximale n'excède pas de plus de 40°C la température de ramollissement de la colle.

On prévoit ici également que les spires de l'antenne 8 ne se situent pas dans la zone 24 réservée aux caractères embossés définie par la norme ISO ou les spécifications émises par les organismes bancaires (une telle zone d'embossage 24 s'étend classiquement entre 4 mm et 23 mm par rapport au bord inférieur de la carte, avec des marges latérales de l'ordre de 5 mm..

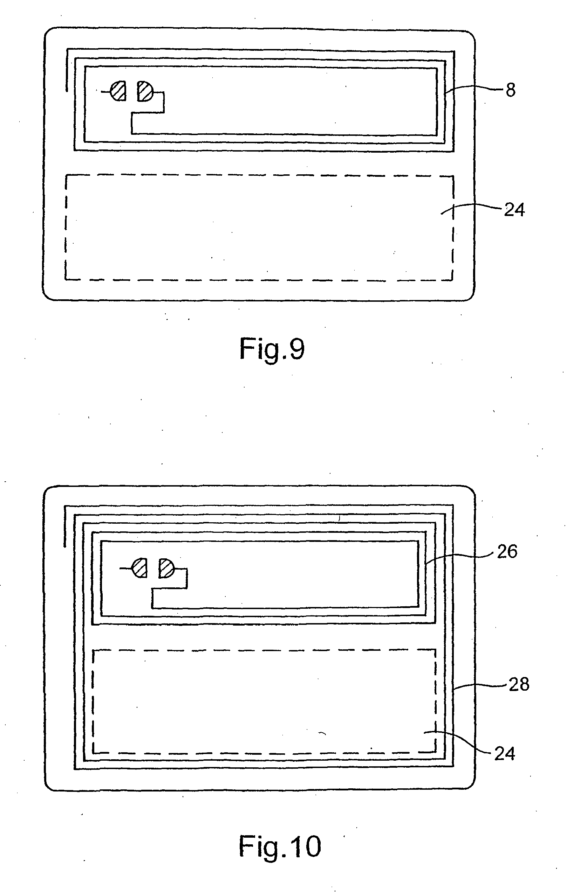

A cet effet, on peut réaliser des antennes dont les spires se situent au dessus de ladite zone d'embossage 24 dans le plan de la carte, comme illustré en figure 9. On obtient toutefois des antennes de portée réduite du fait de leur faible surface équivalente.

On propose ici de réaliser une partie des spires en périphérie de la carte, passant au-dessous de la zone d'embossage 24 dans le plan de la carte, et une autre partie restant au-dessus de la zone d'embossage 24, comme montré en figure 10. Cette configuration permet de maximiser la surface comprise à l'intérieur des spires et donc d'optimiser les performances de l'antenne (portée notamment).

La partie des spires située au-dessus de la zone d'embossage (et donc dans la région de la carte qui porte le microcircuit 2) forme donc un premier enroulement 26 composé d'un premier nombre de spires, par exemple de 2 à 5 spires (ici 3 spires). La partie des spires située sur la périphérie de la carte forme quant à elle un second enroulement 28, connecté en série avec le premier enroulement 26 et composé d'un second nombre de spires, par exemple de 2 à 5 spires (ici 2 spires).

Les spires sont réalisées comme déjà mentionné sous forme de pistes conductrices, avec une largeur habituellement comprise entre 0,1 mm et 0,4 mm et séparées entre elles par un espacement compris en 0,1 mm et 0,4 mm. Les modes de réalisation décrits ci-dessus ne constituent que des exemples possibles de mise en oeuvre de l'invention qui ne s'y limite pas.

## Revendications

1. Procédé de fabrication d'une carte à microcircuit **caractérisé en ce qu'**il comprend les étapes suivantes :
- dépôt du microcircuit (2) sur une surface (3) portant au moins une plage de connexion (10) avec interposition d'un adhésif (4),
- application d'une pression sur le microcircuit (2) à l'aide d'une tête de dépôt chauffante, cette application d'une pression avec chauffage permettant un durcissement de l'adhésif (4).
- lamination à chaud avec une température maximale donnée d'au moins une couche de compensation (14) solidaire de ladite surface (3), l'adhésif (4) étant visqueux à ladite température maximale, la température de ramollissement de l'adhésif et ladite température maximale, supérieure à cette température de ramollissement, différant de 40° C ou moins.

2. Procédé de fabrication selon la revendication 1, dans lequel l'adhésif est une colle thermodurcissable ayant une température de transition vitreuse constituant ladite température de ramollissement.

3. Procédé de fabrication selon la revendication 1 ou la revendication 2, dans lequel le microcircuit (2) a une épaisseur dans une direction essentiellement perpendiculaire à ladite surface (3) inférieure à 160 µm.

4. Procédé de fabrication selon la revendication 3, dans lequel ladite épaisseur est supérieure à 120 µm.

5. Procédé de fabrication selon l'une des revendications 1 à 4, dans lequel la carte à microcircuit a une épaisseur comprise entre 680 µm et 840 µm.

6. Procédé de fabrication selon l'une des revendications 1 à 5, dans lequel au moins un contact (21) du microcircuit (2) est situé face à ladite plage de connexion (10) avec interposition d'un élément conducteur (6).

7. Procédé de fabrication selon la revendication 2, dans lequel l'application d'une pression avec chauffage permet une polymérisation de l'adhésif (4).

8. Procédé de fabrication selon l'une des revendications 1 à 7, dans lequel la carte à microcircuit comprend une antenne magnétique (8) formée d'un premier enroulement (26) comprenant au moins une spire et d'un second enroulement (28) comprenant au moins une spire,
dans lequel une zone d'embossage (24) de la carte est située à l'extérieur du premier enroulement (26) et à l'intérieur du second enroulement (28) et dans lequel le premier enroulement (26) est situé dans une partie rectangulaire de la carte à microcircuit située à l'extérieur de la zone d'embossage (24).

9. Procédé de fabrication selon la revendication 8, dans lequel le premier enroulement (26) et le second enroulement (28) sont connectés en série.

10. Procédé de fabrication selon la revendication 8 ou 9, dans lequel le second enroulement (28) est situé à la périphérie de la carte à microcircuit.

11. Procédé de fabrication selon l'une des revendications 8 à 10, dans lequel ladite partie rectangulaire porte le microcircuit (2).

12. Procédé de fabrication selon l'une des revendications 8 à 11, dans lequel la zone d'embossage s'étend entre 4 mm et 23 mm par rapport à un bord de la carte.

## Patentansprüche

1. Verfahren zum Herstellen einer Mikroschaltungskarte, **dadurch gekennzeichnet, dass** es die folgenden Schritte umfasst:
- Aufbringen der Mikroschaltung (2) auf eine Oberfläche (3), die wenigstens eine Verbindungsanschlussfläche (10) trägt, unter Einfügung eines Klebstoffs (4),
- Ausüben eines Drucks auf die Mikroschaltung (2) mit Hilfe eines Heizaufbringkopfes, wobei diese Ausübung eines Drucks unter Heizen ein Härten des Klebstoffs (4) ermöglicht,
- Laminieren mit Wärme mit einer gegebenen Maximaltemperatur wenigstens einer Ausgleichsschicht (14), die mit der Oberfläche (3) fest verbunden ist, wobei der Klebstoff (4) bei der Maximaltemperatur viskos ist, wobei sich die Erweichungstemperatur des Klebstoffs und die Maximaltemperatur, die höher als diese Erweichungstemperatur ist, um 40 °C oder weniger unterscheiden.

2. Herstellungsverfahren nach Anspruch 1, wobei der Klebstoff ein wärmehärtbarer Klebstoff ist, der eine Glasübergangstemperatur besitzt, die die Erweichungstemperatur bildet.

3. Herstellungsverfahren nach Anspruch 1 oder Anspruch 2, wobei die Mikroschaltung (2) in einer zu der Oberfläche (3) im Wesentlichen senkrechten Richtung eine Dicke besitzt, die kleiner als 160 µm ist.

4. Herstellungsverfahren nach Anspruch 3, wobei die Dicke größer als 120 µm ist.

5. Herstellungsverfahren nach einem der Ansprüche 1 bis 4, wobei die Mikroschaltungskarte eine Dicke im Bereich von 680 µm bis 840 µm besitzt.

6. Herstellungsverfahren nach einem der Ansprüche 1 bis 5, wobei sich wenigstens ein Kontakt (21) der Mikroschaltung (2) unter Einfügung eines Leiterelements (6) gegenüber dem Verbindungsanschlussbereich (10) befindet.

7. Herstellungsverfahren nach Anspruch 2, wobei die Ausübung eines Drucks unter Heizen eine Polymerisation des Klebstoffs (4) ermöglicht.

8. Herstellungsverfahren nach einem der Ansprüche 1 bis 7, wobei die Mikroschaltungskarte eine magnetische Antenne (8) umfasst, die aus einer ersten Wicklung (26), die wenigstens eine Windung aufweist, und aus einer zweiten Wicklung (28), die wenigstens eine Windung aufweist, gebildet ist,
wobei sich eine Ambossbildungszone (24) der Karte außerhalb der ersten Wicklung (26) und innerhalb der zweiten Wicklung (28) befindet und wobei sich die erste Wicklung (26) in einem rechtwinkligen Teil der Mikroschaltungskarte befindet, der sich außerhalb der Ambossbildungszone (24) befindet.

9. Herstellungsverfahren nach Anspruch 8, wobei die erste Wicklung (26) und die zweite Wicklung (28) in Reihe geschaltet sind.

10. Herstellungsverfahren nach Anspruch 8 oder 9, wobei sich die zweite Wicklung (28) am Umfang der Mikroschaltungskarte befindet.

11. Herstellungsverfahren nach einem der Ansprüche 8 bis 10, wobei der rechtwinklige Teil die Mikroschaltung (2) trägt.

12. Herstellungsverfahren nach einem der Ansprüche 8 bis 11, wobei sich die Ambossbildungszone in Bezug auf einen Rand der Karte in einem Bereich von 4 mm bis 23 mm erstreckt.

## Claims

1. Method of fabricating a microcircuit card, **characterized in that** it comprises the following steps:
- depositing the microcircuit (2) on a surface (3) carrying at least one connecting land (10) with an adhesive (4) between them;
- applying pressure to the microcircuit (2) using a heated deposition head, this application of pressure and heat making it possible to set the adhesive (4); and
- hot lamination with a given maximum temperature of at least one compensation layer (14) attached to said surface (3), the adhesive (4) being viscous at said maximum temperature, the softening temperature of the adhesive and said maximum temperature, which is higher than said softening temperature, differing by 40°C or less.

2. Fabrication method according to Claim 1, wherein the adhesive is a heat-set glue having a glass transition temperature that is said softening temperature.

3. Fabrication method according to Claim 1 or Claim 2, wherein the microcircuit (2) has a thickness in a direction essentially perpendicular to said surface (3) of less than 160 µm.

4. Fabrication method according to Claim 3, wherein said thickness is greater than 120 µm.

5. Fabrication method according to one of Claims 1 to 4, wherein the microcircuit card has a thickness between 680 µm and 840 µm.

6. Fabrication method according to one of Claims 1 to 5, wherein at least one contact (21) of the microcircuit (2) is located facing said connecting land (10) with a conductive member (6) disposed between them.

7. Fabrication method according to Claim 2, wherein the application of pressure and heat makes it possible to polymerise the adhesive (4).

8. Fabrication method according to one of Claims 1 to 7, wherein the microcircuit card comprises a magnetic antenna (8) formed of a first winding (26) comprising at least one turn and a second winding (28) comprising at least one turn,
wherein an embossing area (24) of the card is located outside the first winding (26) and inside the second winding (28) and wherein the first winding (26) is located in a rectangular portion of the microcircuit card located outside the embossing area (24).

9. Fabrication method according to Claim 8, wherein the first winding (26) and the second winding (28) are connected in series.

10. Fabrication method according to Claim 8 or 9, wherein the second winding (28) is located at the periphery of the microcircuit card.

11. Fabrication method according to one of Claims 8 to 10, wherein said rectangular portion carries the microcircuit (2).

12. Fabrication method according to one of Claims 8 to 11, wherein the embossing area extends between 4 mm and 23 mm relative to one edge of the card.
